# EUROPEAN PATENT SPECIFICATION

(11) **EP 4 056 823 B1**
(45) Date of publication and mention of the grant of the patent: **05.07.2023**
(21) Application number: 21190026.1
(22) Date of filing: 06.08.2021
(51) Int. Cl.: F01N 5/02

(54) **THERMOELECTRIC GENERATOR FOR VEHICLE**
THERMOELEKTRISCHER GENERATOR FÜR FAHRZEUG
GÉNÉRATEUR THERMOÉLECTRIQUE POUR VÉHICULE

(30) Priority: 10.03.2021 KR 20210031575
(43) Date of publication of application: 14.09.2022
(73) Proprietor: HYUNDAI MOTOR COMPANY, Seoul 06797 (KR); Kia Corporation, Seocho-gu Seoul 06797 (KR)
(72) Inventor: KIM, Byung Wook, 18280 Gyeonggi-do (KR); LEE, Min Jae, 18280 Gyeonggi-do (KR)
(74) Representative: Isarpatent

(56) References cited:
- EP-A1- 2 952 706
- US-A1- 2014 007 915

## Description

### TECHNICAL FIELD

The present disclosure relates to a thermoelectric generator for a vehicle, and more particularly, to a thermoelectric generator for a vehicle, which is capable of adjusting whether to supply thermal energy to the thermoelectric generator depending on operating conditions of a vehicle.

### BACKGROUND ART

Recently, a thermoelectric generator (TEG) has been developed that generates electricity required for a vehicle using thermal energy (e.g., exhaust heat of exhaust gas) produced in the vehicle. The thermoelectric generator uses a thermoelectric element that generates electricity using a difference in temperature between a high-temperature part and a low-temperature part. The thermoelectric generator generates electricity required for the vehicle by using exhaust heat as the high-temperature part and using a coolant as the low-temperature part.

Meanwhile, the thermoelectric generator may be damaged when excessive thermal energy is supplied to the thermoelectric generator. Therefore, the supply of thermal energy to the thermoelectric generator needs to be cut off when the thermal energy (e.g., a temperature of exhaust gas) to be supplied to the thermoelectric generator exceeds a preset condition, see for example US2014/007915A1.

In the related art, however, a separate bypass flow path and a separate valve, which allow the thermal energy to bypass the thermoelectric generator, need to be provided to cut off the supply of the thermal energy to the thermoelectric generator, which complicates a structure of the thermoelectric generator and degrades a degree of design freedom and spatial utilization of the thermoelectric generator.

Therefore, recently, various studies have been conducted to simplify the structure of the thermoelectric generator and selectively adjust the supply of thermal energy to the thermoelectric generator, but the study results are still insufficient. Accordingly, there is a need to develop a technology for simplifying the structure of the thermoelectric generator and selectively adjusting the supply of thermal energy to the thermoelectric generator.

### SUMMARY

The present disclosure provides a thermoelectric generator for a vehicle, which is capable of adjusting whether to supply thermal energy to the thermoelectric generator depending on the operating conditions of a vehicle.

The present disclosure has also been made in an effort to inhibit a supply of excessive thermal energy to a thermoelectric generator. The present disclosure has also been made in an effort to improve the stability and reliability of a thermoelectric generator, minimize damage to the thermoelectric generator, and extend the lifespan of the thermoelectric generator.

The present disclosure has also been made in an effort to actively adjust whether to supply thermal energy to a thermoelectric generator depending on the operating conditions without separately providing a bypass flow path. The present disclosure has also been made in an effort to simplify a structure of a thermoelectric generator and improve spatial utilization and a degree of design freedom of the thermoelectric generator.

The objects to be achieved by the embodiments are not limited to the above-mentioned objects, but also include objects or effects that may be understood from the solutions or embodiments described below.

In one aspect, the present disclosure provides a thermoelectric generator for a vehicle that may include: a thermoelectric material unit including unit thermoelectric materials and provided to be movable in a direction in which the thermoelectric material unit approaches a heated body of a vehicle and a direction in which the thermoelectric material unit moves away from the heated body; a thermal expansion member provided between the thermoelectric material unit and the heated body and configured to be selectively expanded or contracted in response to a temperature of the heated body; and an elastic member configured to elastically support a movement of the thermoelectric material unit relative to the heated body.

This to simplify a structure of the thermoelectric generator and improve stability and reliability of the thermoelectric generator. In other words, the thermoelectric generator may be damaged when excessive thermal energy is supplied to the thermoelectric generator. Therefore, the supply of thermal energy to the thermoelectric generator needs to be cut off when the thermal energy to be supplied to the thermoelectric generator exceeds a preset condition. In the related art, however, a separate bypass flow path and a separate valve, which allow the thermal energy to bypass the thermoelectric generator, need to be provided to cut off the supply of the thermal energy to the thermoelectric generator, which complicates a structure of the thermoelectric generator and degrades a degree of design freedom and spatial utilization of the thermoelectric generator.

However, according to the present disclosure, the heat transfer between the thermoelectric material unit and the heated body may be maintained (the thermoelectric material unit and the heated body are in contact with each other) or cut off (the thermoelectric material unit and the heated body are separated from each other) through the thermal expansion member which is selectively expanded or contracted in response to the temperature of the heated body. Therefore, it is possible to obtain an advantageous effect of inhibiting the supply of excessive thermal energy to the thermoelectric material unit and minimizing the damage to the thermoelectric material unit.

Among other things, the embodiment of the present disclosure may selectively adjust whether to supply the thermal energy to the thermoelectric material unit without providing a separate bypass flow path and a separate valve that allow the thermal energy of the heated body to bypass the thermoelectric material unit. Therefore, it is possible to obtain an advantageous effect of simplifying the structure of the thermoelectric generator and improving the degree of design freedom and the spatial utilization of the thermoelectric generator.

The thermoelectric material unit may have various structures including the unit thermoelectric materials for converting the thermal energy, generated from a heat exchanger, into electrical energy. As an example, the unit thermoelectric materials may include at least any one of an N-type thermoelectric material and a P-type thermoelectric material.

According to the exemplary embodiment of the present disclosure, the thermoelectric material unit may be in contact with the heat exchanger when the thermal expansion member is contracted, and the thermoelectric material unit may be spaced apart from the heat exchanger when the thermal expansion member is expanded.

As described above, the thermal expansion member may be provided between the thermoelectric material unit and the heat exchanger, and the thermal expansion member may be selectively contracted or expanded between the thermoelectric material unit and the heat exchanger. Therefore, the thermal expansion member may move the thermoelectric material unit in the direction in which the thermoelectric material unit approaches the heat exchanger and the direction in which the thermoelectric material unit moves away from the heat exchanger.

Therefore, when the thermal energy of the heat exchanger is excessively high (e.g., the temperature of the heat exchanger is greater than a limit temperature at which the thermoelectric material unit begins to be damaged), the thermoelectric material unit may be spaced apart from the heat exchanger, which may inhibit the transfer (conduction) of excessive thermal energy to the thermoelectric material unit.

According to the exemplary embodiment of the present disclosure, the thermoelectric generator for a vehicle may include a housing provided to surround the heated body, and the elastic member may be interposed to be elastically deformable between the housing and the thermoelectric material unit.

According to the exemplary embodiment of the present disclosure, the elastic member may include: a contact portion being in elastic contact with the thermoelectric material unit; a fixing portion provided at a first end of the contact portion and fixed to the housing; and a movable portion provided at a second end of the contact portion and disposed to be movable relative to the housing. In particular, the contact portion, the fixing portion, and the movable portion may be made by continuously bending a metal member.

As described above, a first end (the fixing portion) of the elastic member may be fixed to the housing, and a second end (the movable portion) of the elastic member may be disposed as a free end. Therefore, even though the thermoelectric material unit moves in the direction in which the thermoelectric material unit moves away from the heat exchanger (i.e., in the direction in which the thermoelectric material unit approaches the elastic member) as the thermal expansion member is expanded, an increase in force applied to (acting on) the thermoelectric material unit by the elastic member (e.g., the contact portion) may be minimized. Therefore, it is possible to obtain an advantageous effect of minimizing damage to and deformation of the thermoelectric material unit.

According to the exemplary embodiment of the present disclosure, the thermoelectric generator for a vehicle may include a thermal conduction member provided between the thermoelectric material unit and the heated body, and the thermoelectric material unit may come into contact with the heated body through the thermal conduction member. This is to uniformly transfer the thermal energy of the heat exchanger to the entire thermoelectric material unit.

In other words, the high-temperature exhaust gas discharged from an engine may be introduced into a first end (e.g., an inlet) of the heat exchanger, pass through the inside of the heat exchanger, and then be discharged to a second end (e.g., an outlet) of the heat exchanger. Therefore, a temperature of a portion adjacent to the first end of the heat exchanger may be relatively greater than a temperature of a portion adjacent to the second end of the heat exchanger. Accordingly, the thermal energy of the heat exchanger may be difficult to uniformly transfer to the entire thermoelectric material unit.

However, in the embodiment of the present disclosure, the thermoelectric material unit may come into contact with the thermal conduction member through the thermal conduction member provided between the thermoelectric material unit and the heat exchanger. Therefore, it is possible to obtain an advantageous effect of uniformly transferring the thermal energy of the heat exchanger over the entire region of the thermoelectric material unit.

As described above, in the embodiment of the present disclosure, the thermal energy of the heat exchanger may be uniformly transferred to the entire thermoelectric material unit, which may inhibit the thermoelectric material unit from being locally overheated. Therefore, it is possible to obtain an advantageous effect of improving the stability and reliability of the thermoelectric material unit and extending the lifespan of the thermoelectric material unit.

According to the exemplary embodiment of the present disclosure, the thermoelectric generator for a vehicle may include a stopper configured to restrict the thermal expansion member with respect to the thermoelectric material unit. The stopper may have various structures capable of restricting the thermal expansion member with respect to the thermoelectric material unit. In particular, the stopper may be provided on at least any one of the thermoelectric material unit and the heated body.

As an example, the stopper may include: a first stopper protrusion disposed in a first direction; and a second stopper protrusion connected to the first stopper protrusion and disposed in a second direction that intersects the first direction, and the first stopper protrusion and the second stopper protrusion may cooperatively surround at least a part of a periphery of the thermal expansion member.

As described above, in the embodiment of the present disclosure, since the first and second stopper protrusions are provided in the first and second directions intersecting each other, respectively, it is possible to obtain an advantageous effect of more stably maintaining the arrangement state of the thermal expansion member with respect to the thermoelectric material unit. As another example, the stopper may include a stopper groove provided in at least any one of the thermoelectric material unit and the heated body, and the thermal expansion member may be accommodated in the stopper groove.

### BRIEF DESCRIPTION OF THE DRAWINGS

FIG. 1 is a view for explaining an example in which a thermoelectric generator for a vehicle according to an embodiment of the present disclosure is mounted.
FIG. 2 is a view for explaining a heated body related to the thermoelectric generator for a vehicle according to the embodiment of the present disclosure.
FIG. 3 is a view for explaining the thermoelectric generator for a vehicle according to the embodiment of the present disclosure.
FIG. 4 is a view for explaining a thermoelectric material unit of the thermoelectric generator for a vehicle according to the embodiment of the present disclosure.
FIG. 5 is a view for explaining a thermal expansion member of the thermoelectric generator for a vehicle according to the embodiment of the present disclosure.
FIGS. 6 and 7 are views for explaining an elastic member of the thermoelectric generator for a vehicle according to the embodiment of the present disclosure.
FIGS. 8 and 9 are views for explaining a stopper of the thermoelectric generator for a vehicle according to the embodiment of the present disclosure.
FIGS. 10 to 12 are views for explaining another example of the stopper of the thermoelectric generator for a vehicle according to the embodiment of the present disclosure.

### DETAILED DESCRIPTION

It is understood that the term "vehicle" or "vehicular" or other similar term as used herein is inclusive of motor vehicles in general such as passenger automobiles including sports utility vehicles (SUV), buses, trucks, various commercial vehicles, watercraft including a variety of boats and ships, aircraft, and the like, and includes hybrid vehicles, electric vehicles, combustion, plug-in hybrid electric vehicles, hydrogen-powered vehicles and other alternative fuel vehicles (e.g. fuels derived from resources other than petroleum).

Although exemplary embodiment is described as using a plurality of units to perform the exemplary process, it is understood that the exemplary processes may also be performed by one or plurality of modules. Additionally, it is understood that the term controller/control unit refers to a hardware device that includes a memory and a processor and is specifically programmed to execute the processes described herein. The memory is configured to store the modules and the processor is specifically configured to execute said modules to perform one or more processes which are described further below.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items.

Unless specifically stated or obvious from context, as used herein, the term "about" is understood as within a range of normal tolerance in the art, for example within 2 standard deviations of the mean. "About" can be understood as within 10%, 9%, 8%, 7%, 6%, 5%, 4%, 3%, 2%, 1%, 0.5%, 0.1%, 0.05%, or 0.01% of the stated value. Unless otherwise clear from the context, all numerical values provided herein are modified by the term "about."

Hereinafter, embodiments of the present disclosure will be described in detail with reference to the accompanying drawings. However, the technical spirit of the present disclosure is not limited to some embodiments described herein but may be implemented in various different forms.

In addition, unless otherwise specifically and explicitly defined and stated, the terms (including technical and scientific terms) used in the embodiments of the present disclosure may be construed as the meaning which may be commonly understood by the person with ordinary skill in the art to which the present disclosure pertains. The meanings of the commonly used terms such as the terms defined in dictionaries may be interpreted in consideration of the contextual meanings of the related technology. In addition, the terms used in the embodiments of the present disclosure are for explaining the embodiments, not for limiting the present disclosure.

In the present specification, unless particularly stated otherwise, a singular form may also include a plural form. The expression "at least one (or one or more) of A, B, and C" may include one or more of all combinations that can be made by combining A, B, and C. In addition, the terms such as first, second, A, B, (a), and (b) may be used to describe constituent elements of the embodiments of the present disclosure.

These terms are used only for the purpose of discriminating one constituent element from another constituent element, and the nature, the sequences, or the orders of the constituent elements are not limited by the terms. Further, when one constituent element is described as being 'connected', 'coupled', or 'attached' to another constituent element, one constituent element may be connected, coupled, or attached directly to another constituent element or connected, coupled, or attached to another constituent element through still another constituent element interposed therebetween.

In addition, the expression "one constituent element is provided or disposed above (on) or below (under) another constituent element" includes not only a case in which the two constituent elements are in direct contact with each other, but also a case in which one or more other constituent elements are provided or disposed between the two constituent elements. The expression "above (on) or below (under)" may mean a downward direction as well as an upward direction based on one constituent element.

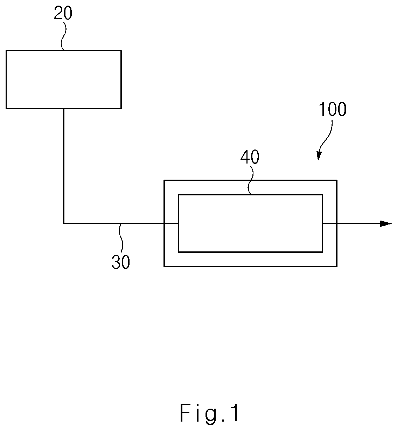

Referring to FIGS. 1 to 12, a thermoelectric generator 100 for a vehicle according to an embodiment of the present disclosure may include: a thermoelectric material unit 200 including unit thermoelectric materials 220 and provided to be movable in a direction in which the thermoelectric material unit 200 approaches a heated body of a vehicle and a direction in which the thermoelectric material unit 200 moves away from the heated body; thermal expansion members 300 disposed between the thermoelectric material unit 200 and the heated body and configured to be selectively expanded or contracted in response to a temperature of the heated body; and elastic members 400 configured to elastically support a movement of the thermoelectric material unit 200 relative to the heated body.

For reference, the thermoelectric generator 100 for a vehicle according to the embodiment of the present disclosure may be applied to various heated bodies (or heated parts) of the vehicle to convert thermal energy of the heated body into electrical energy, and the present disclosure is not restricted or limited by the type and structure of the heated body to which the thermoelectric generator 100 for a vehicle is applied. For example, the thermoelectric generator 100 for a vehicle according to the embodiment of the present disclosure may be used to convert thermal energy, which is generated from a high-temperature exhaust gas discharged from an engine 20 of the vehicle, into electrical energy.

Hereinafter, an example will be described in which the thermoelectric generator 100 for a vehicle according to the embodiment of the present disclosure receives thermal energy from a heat exchanger 40 connected to an exhaust pipe 30 for discharging a high-temperature exhaust gas discharged from the engine 20 and converts the thermal energy into electrical energy.

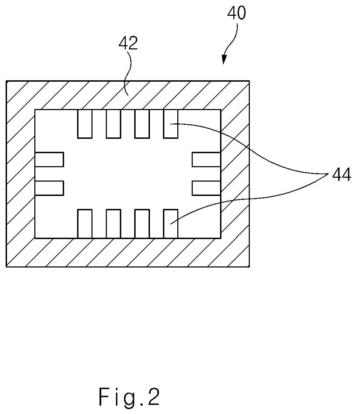

The heat exchanger 40 may have various structures capable of exchanging heat with the exhaust gas being discharged through the exhaust pipe 30, and the present disclosure is not restricted or limited by the type and structure of the heat exchanger 40. For example, referring to FIG. 2, the heat exchanger 40 may include a heat exchanger housing 42 that defines a path through which the exhaust gas flows, and a plurality of fins 44 provided inside the heat exchanger housing 42.

The thermoelectric material unit 200 is provided to be movable in the direction in which the thermoelectric material unit 200 approaches the heat exchanger 40 (i.e., the heated body) and the direction in which the thermoelectric material unit 200 moves away from the heat exchanger 40. The thermoelectric material unit 200 includes the unit thermoelectric materials 220 for converting the thermal energy, generated from the heat exchanger 40, into electrical energy.

Hereinafter, an example will be described in which the thermoelectric material units 200 are provided at upper and lower sides of the heat exchanger 40, respectively. According to another embodiment of the present disclosure, the thermoelectric material unit may be provided only at one of the upper and lower sides of the heat exchanger. The unit thermoelectric material 220 may have various structures capable of converting the thermal energy, generated from the heat exchanger 40, into electrical energy, and the present disclosure is not restricted or limited by the type and structure of the unit thermoelectric material 220.

The unit thermoelectric material 220 is also called a Peltier element, a thermoelectric cooler (TEC), and the like as an element for converting thermal energy into electrical energy (or electrical energy into thermal energy). The unit thermoelectric material 220 may generate the electric current using an effect (Seebeck effect) that generates an electromotive force because of a difference in temperature between two opposite ends of the unit thermoelectric material 220.

According to the exemplary embodiment of the present disclosure, the unit thermoelectric materials 220 may include at least any one of an N-type thermoelectric material 222 and a P-type thermoelectric material 224. Hereinafter, an example will be described in which the unit thermoelectric materials 220 include both the N-type thermoelectric material 222 and the P-type thermoelectric material 224. Alternatively, the unit thermoelectric materials 220 may include only one of the N-type thermoelectric material 222 and the P-type thermoelectric material 224.

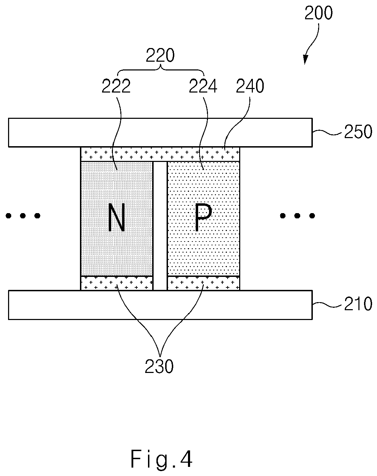

For example, referring to FIG. 4, the thermoelectric material unit 200 may include a first substrate 210, the N-type thermoelectric material 222 provided on the first substrate 210, the P-type thermoelectric material 224 provided on the first substrate 210 and spaced apart from the N-type thermoelectric material 222, first electrodes 230 individually connected to first end of the N-type thermoelectric material 222 and the first end of the P-type thermoelectric material 224, respectively, a second electrode 240 configured to electrically connect the second end of the N-type thermoelectric material 222 and the second end of the P-type thermoelectric material 224, and a second substrate 250 configured to support the second electrode 240.

The first substrate 210 and the second substrate 250 may be provided to maintain the shape of the thermoelectric material unit 200 and protect the unit thermoelectric materials 220 from an external environment. The materials and structures of the first and second substrates 210 and 250 may be variously changed in accordance with required conditions and usage environments, and the present disclosure is not restricted or limited by the materials and structures of the first and second substrates 210 and 250.

The N-type thermoelectric materials 222 and the P-type thermoelectric materials 224 may be alternately disposed to be spaced apart from one another in a straight direction. According to another embodiment of the present disclosure, the N-type thermoelectric materials and the P-type thermoelectric materials may be arranged in a curved shape or other shapes, and the present disclosure is not restricted or limited by the shapes in which the N-type thermoelectric materials and the P-type thermoelectric materials are arranged.

The first electrodes 230 may be individually connected (electrically connected) to a first end (e.g., a lower end) of the N-type thermoelectric material 222 and a first end (e.g., a lower end) of the P-type thermoelectric material 224, respectively. The first electrodes 230 may be made of a typical metal material that may be electrically connected to the N-type thermoelectric material 222 and the P-type thermoelectric material 224, and the present disclosure is not restricted or limited by the material of the first electrode 230. For example, the first electrode 230 may be made of at least one material selected from a group consisting of copper (Cu), nickel (Ni), carbon (C), titanium (Ti), tungsten (W), silver (Ag), platinum (Pt), palladium (Pd), and aluminum (Al).

The second electrode 240 is provided to electrically connect a second end (e.g., an upper end) of the N-type thermoelectric material 222 and a second end (e.g., an upper end) of the P-type thermoelectric material 224. More specifically, the second electrode 240 is structured to be simultaneously connected to the N-type thermoelectric material 222 and the P-type thermoelectric material 224, and the present disclosure is not restricted or limited by the structure of the second electrode 240.

The second electrode 240 may be made of a typical metal material capable of electrically connecting the N-type thermoelectric material 222 and the P-type thermoelectric material 224, and the present disclosure is not restricted or limited by the material of the second electrode 240. For example, the second electrode 240 may be made of at least one material selected from a group consisting of copper (Cu), nickel (Ni), carbon (C), titanium (Ti), tungsten (W), silver (Ag), platinum (Pt), palladium (Pd), and aluminum (Al).

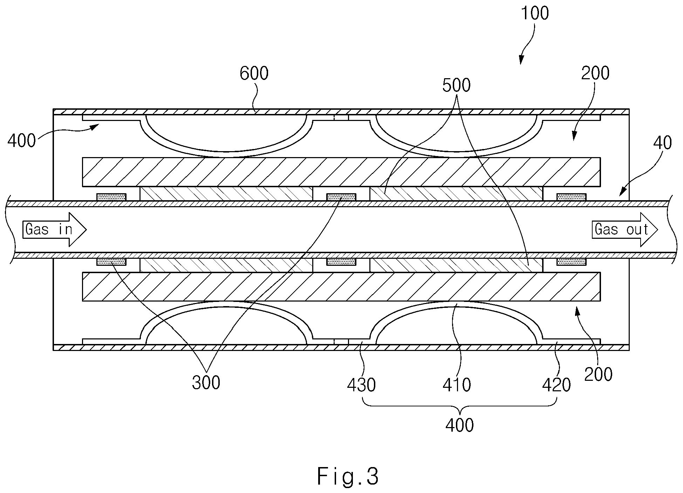

For reference, in the present disclosure, the movements of the thermoelectric material unit 200 in the direction in which the thermoelectric material unit 200 approaches the heat exchanger 40 of the vehicle and the direction in which the thermoelectric material unit 200 moves away from the heat exchanger 40 may refer to the movement (e.g., rectilinear movement) of the thermoelectric material unit 200 from a first position, at which the thermoelectric material unit 200 abuts on the heated body (e.g., the heat exchanger), to a second position at which the thermoelectric material unit 200 is spaced apart from the heated body. For example, the thermoelectric material unit 200 may rectilinearly move from the first position to the second position in the vertical direction based on FIG. 3. According to another embodiment of the present disclosure, the thermoelectric material unit may be configured to move from the first position to the second position in a curved manner.

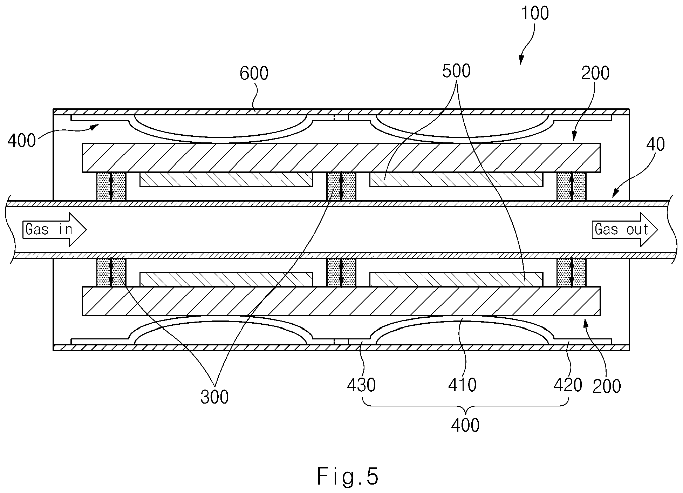

Referring to FIG. 3, in a state in which the thermoelectric material unit 200 is positioned at the first position, the thermoelectric material unit 200 may be in contact with the heat exchanger 40, and the thermal energy of the heat exchanger 40 may be transferred to the thermoelectric material unit 200. In contrast, referring to FIG. 5, in a state in which the thermoelectric material unit 200 is positioned at the second position, the thermoelectric material unit 200 may be spaced apart from the heat exchanger 40, and the transfer (conduction) of the thermal energy from the heat exchanger 40 to the thermoelectric material unit 200 may be cut off.

The thermal expansion member 300 may be provided between the thermoelectric material unit 200 and the heated body, and selectively expanded or contracted in response to a temperature of the heated body (the heat exchanger). The thermal expansion member 300 may be made of various materials capable of being selectively expanded or contracted in response to the temperature of the heated body, and the present disclosure is not restricted or limited by the material and property of the thermal expansion member.

For example, the thermal expansion member 300 may be made of a typical metal material, such as aluminum, silver, copper, gold, SUS304, or nickel, capable of being selectively expanded or contracted in response to the temperature of the heat exchanger 40. According to another embodiment of the present disclosure, the thermal expansion member 300 may be made of a nonmetal material such as epoxy, acrylic, or phenolic resin.

In addition, the structure of the thermal expansion member 300 may be variously changed in accordance with required conditions and design specifications. For example, the thermal expansion member 300 may be provided in the form of a column having a quadrangular cross-section. According to another embodiment of the present disclosure, the thermal expansion member may have a circular cross-section or other cross-sectional shapes.

According to the exemplary embodiment of the present disclosure, the thermoelectric material unit 200 may be in contact with the heat exchanger 40 when the thermal expansion member 300 is contracted, and the thermoelectric material unit 200 may be spaced apart from the heat exchanger 40 when the thermal expansion member 300 is expanded.

As described above, the thermal expansion member 300 may be provided between the thermoelectric material unit 200 and the heat exchanger 40, and the thermal expansion member 300 may be selectively contracted or expanded between the thermoelectric material unit 200 and the heat exchanger 40. Therefore, the thermal expansion member 300 may move the thermoelectric material unit 200 in the direction in which the thermoelectric material unit 200 approaches the heat exchanger 40 and the direction in which the thermoelectric material unit 200 moves away from the heat exchanger 40.

Therefore, when the thermal energy of the heat exchanger 40 is excessively high (e.g., the temperature of the heat exchanger 40 is greater than a limit temperature at which the thermoelectric material unit begins to be damaged), the thermoelectric material unit 200 may be spaced apart from the heat exchanger 40, which may inhibit the transfer (conduction) of excessive thermal energy to the thermoelectric material unit 200.

Referring to FIGS. 3 and 5 to 7, the elastic member 400 is provided to elastically support the movements of the thermoelectric material unit 200 relative to the heated body (the movements in the direction in which the thermoelectric material unit 200 approaches the heat exchanger 40 and the direction in which the thermoelectric material unit 200 moves away from the heat exchanger 40).

According to the exemplary embodiment of the present disclosure, the thermoelectric generator 100 for a vehicle may include a housing 600 configured to surround the heated body, and the elastic member 400 may be interposed to be elastically deformable between the housing 600 and the thermoelectric material unit 200. For example, the housing 600 may be provided in the form of a quadrangular box having a receiving space therein, and the elastic members 400 may be disposed on upper and lower inner surfaces of the housing 600, respectively (based on FIG. 3).

Various types of elastic members 400 capable of elastically supporting the movements of the thermoelectric material unit 200 relative to the heated body (e.g., the heat exchanger) may be used as the elastic member 400, and the present disclosure is not restricted or limited by the type and structure of the elastic member 400.

According to the exemplary embodiment of the present disclosure, the elastic member 400 may include a contact portion 410 being in elastic contact with the thermoelectric material unit 200, a fixing portion 420 provided at a first end of the contact portion 410 and fixed to the housing 600, and a movable portion 430 provided at a second end of the contact portion 410 and disposed to be movable relative to the housing 600.

Hereinafter, an example will be described in which the plurality of elastic members 400 are provided to be spaced apart from one another. The number of elastic members 400 and the arrangement pattern of the elastic members 400 may be variously changed in accordance with required conditions and design specifications.

In particular, the contact portion 410, the fixing portion 420, and the movable portion 430 may be made by continuously bending a metal member (e.g., a metal strap). The contact portion 410 may have various structures capable of being in elastic contact with the thermoelectric material unit 200. For example, the contact portion 410 may have an approximately arc shape (e.g., a "C" shape). According to another embodiment of the present disclosure, the contact portion may be provided in the form of a waveform or in other forms.

The fixing portion 420 is integrally fixed to the housing 600. For example, the fixing portion 420 may be integrally fixed to the housing 600 by welding (WP). According to another embodiment of the present disclosure, the fixing portion may be fixed to the housing by a fastening member such as a bolt.

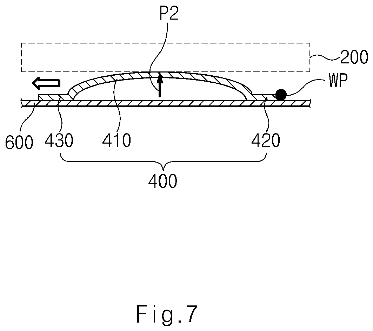

The movable portion 430 is disposed to be movable relative to the housing 600 in a direction in which the movable portion 430 approaches the fixing portion 420 and a direction in which the movable portion 430 moves away from the fixing portion 420 (i.e., a left-right direction based on FIG. 7). In particular, the configuration in which the movable portion 430 is disposed to be movable relative to the housing 600 may refer to that the movable portion 430 is disposed as a free end to be freely movable relative to the housing 600 without being fixed to the housing 600.

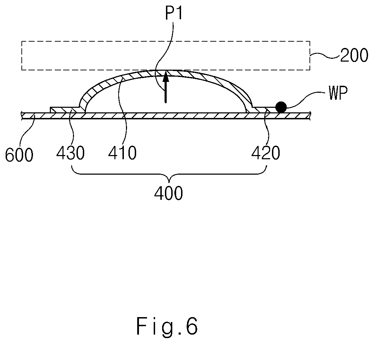

As described above, the first end (the fixing portion) of the elastic member 400 may be fixed to the housing 600, and the second end (the movable portion) of the elastic member 400 may be disposed as a free end. Therefore, even though the thermoelectric material unit 200 moves in the direction the thermoelectric material unit 200 moves away from the heat exchanger 40 (i.e., in the direction in which the thermoelectric material unit 200 approaches the elastic member 400) as the thermal expansion member 300 is expanded, an increase in force P2 applied to (acting on) the thermoelectric material unit 200 by the elastic member 400 (e.g., the contact portion) may be minimized. Therefore, it is possible to obtain an advantageous effect of minimizing damage to and deformation of the thermoelectric material unit 200. In other words, the elastic member 400 is provided to elastically support the thermoelectric material unit 200 with a force P1 applied to the extent that the thermoelectric material unit 200 is not damaged when the thermal expansion member 300 is contracted (see FIG. 6).

Meanwhile, both the two opposite ends of the elastic member 400 may be fixed to the housing 600. However, when the thermal expansion member 300 is expanded in the state in which the two opposite ends of the elastic member 400 are fixed to the housing 600, the thermoelectric material unit 200 moves in the direction in which the thermoelectric material unit 200 approaches the elastic member 400. Thus, the force P2 applied to the thermoelectric material unit 200 by the elastic member 400 (e.g., the contact portion) may inevitably increase (P2 > P21), which may cause damage to and deformation of the thermoelectric material unit 200.

However, in the embodiment of the present disclosure, when the thermal expansion member 300 is expanded, the thermoelectric material unit 200 moves in the direction in which the thermoelectric material unit 200 approaches the elastic member 400, and at the same time, the movable portion 430 moves in the direction in which the movable portion 430 moves away from the fixing portion 420 (see FIG. 7), such that an increase in force P2 with which the elastic member 400 presses the thermoelectric material unit 200 may be minimized. Therefore, it is possible to obtain an advantageous effect of minimizing damage to and deformation of the thermoelectric material unit 200.

In particular, the force P1 with which the elastic member 400 presses the thermoelectric material unit 200 when the thermal expansion member 300 is contracted may be equal to the force P2 with which the elastic member 400 presses the thermoelectric material unit 200 when the thermal expansion member 300 is expanded (P1 = P2).

Referring to FIGS. 3 and 5, according to the exemplary embodiment of the present disclosure, the thermoelectric generator 100 for a vehicle may include thermal conduction members 500 provided between the thermoelectric material unit 200 and the heated body (e.g., the heat exchanger), and the thermoelectric material unit 200 may come into contact with the heated body through the thermal conduction member 500.

For example, the thermal conduction member 500 may be provided on one surface of the thermoelectric material unit that faces the heat exchanger 40. The thermal conduction member 500 is provided to uniformly transfer the thermal energy of the heat exchanger 40 to the entire thermoelectric material unit. In other words, the high-temperature exhaust gas discharged from the engine 20 may be introduced into the first end (e.g., an inlet) of the heat exchanger 40, pass through the inside of the heat exchanger 40, and then be discharged to the second end (e.g., an outlet) of the heat exchanger 40. Therefore, a temperature of a portion adjacent to the first end of the heat exchanger 40 may be relatively greater than a temperature of a portion adjacent to the second end of the heat exchanger 40. Accordingly, the thermal energy of the heat exchanger 40 may be difficult to transfer to the entire thermoelectric material unit.

However, in the embodiment of the present disclosure, the thermoelectric material unit 200 comes into contact with the heat exchanger 40 through the thermal conduction member 500 provided between the thermoelectric material unit 200 and the heat exchanger 40. Therefore, it is possible to obtain an advantageous effect of uniformly transferring the thermal energy of the heat exchanger 40 over the entire region of the thermoelectric material unit.

As described above, in the embodiment of the present disclosure, the thermal energy of the heat exchanger 40 may be uniformly transferred to the entire thermoelectric material unit, which may inhibit the thermoelectric material unit from being locally overheated. Therefore, it is possible to obtain an advantageous effect of improving the stability and reliability of the thermoelectric material unit and extending the lifespan of the thermoelectric material unit.

The thermal conduction member may be made of various materials and have various structures so that the thermal conduction member may uniformly distribute the thermal energy of the heat exchanger 40, and the present disclosure is not restricted or limited by the material and structure of the thermal conduction member. For example, a copper plate having a thin plate shape may be used as the thermal conduction member.

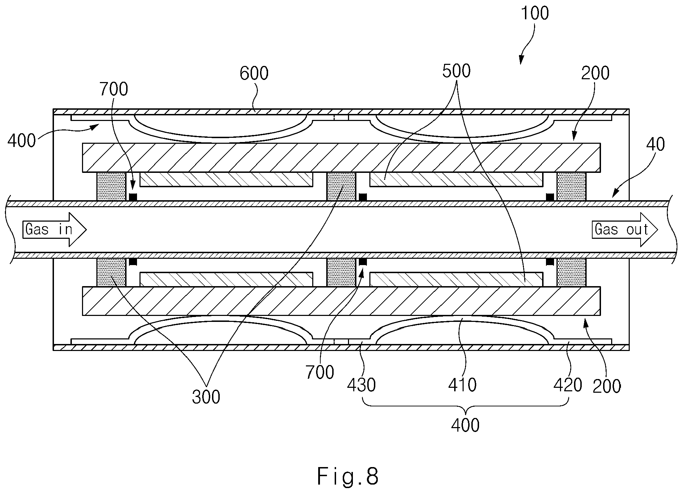

Referring to FIGS. 8 to 12, according to the exemplary embodiment of the present disclosure, the thermoelectric generator 100 for a vehicle may include stoppers 700 configured to restrict the thermal expansion member 300 with respect to the thermoelectric material unit 200. The stopper 700 is provided to stably maintain the arrangement pattern of the thermal expansion member 300 with respect to the thermoelectric material unit 200 (or the heated body) and inhibit the separation of the thermal expansion member 300.

The stopper 700 may have various structures capable of restricting the thermal expansion member 300 with respect to the thermoelectric material unit 200, and the present disclosure is not restricted or limited by the structure of the stopper 700. In particular, the stopper 700 may be provided on at least any one of the thermoelectric material unit 200 and the heated body. According to another embodiment of the present disclosure, the stopper may be provided on another component (e.g., the housing) instead of the thermoelectric material unit and the heated body.

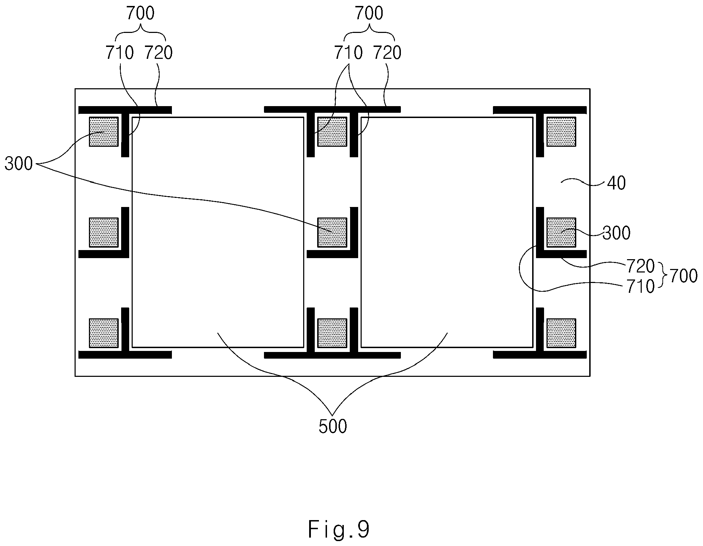

For example, referring to FIGS. 8 and 9, the stopper 700 may be provided on one surface of the heated body that faces the thermoelectric material unit 200. According to the exemplary embodiment of the present disclosure, the stopper 700 may include a first stopper protrusion 710 disposed in a first direction, and a second stopper protrusion 720 connected to the first stopper protrusion 710 and disposed in a second direction that intersects the first direction. The first stopper protrusion 710 and the second stopper protrusion 720 may cooperatively surround at least a part of a periphery of the thermal expansion member 300.

The first stopper protrusion 710 and the second stopper protrusion 720 may protrude from one surface of the heated body that faces the thermoelectric material unit 200. For example, the first stopper protrusion 710 may be disposed in a horizontal direction (based on FIG. 9), and the second stopper protrusion 720 may be disposed in a vertical direction (based on FIG. 9). According to another embodiment of the present disclosure, the first stopper protrusion and the second stopper protrusion may be disposed to be inclined with respect to the horizontal direction (or the vertical direction).

For example, the first stopper protrusion 710 and the second stopper protrusion 720 may cooperatively define at least any one of an approximately 'L' shape, an approximately 'T' shape, and an approximately 'U' shape. Alternatively, the first stopper protrusion 710 and the second stopper protrusion 720 may cooperatively define other shapes (e.g., a 'C' shape or an 'S' shape), and the present disclosure is not restricted or limited by the number of first and second stopper protrusions 710 and 720 and the arrangement pattern of the first and second stopper protrusions 710 and 720.

As described above, in the embodiment of the present disclosure, since the first and second stopper protrusions 710 and 720 are provided in the first and second directions intersecting each other, respectively, it is possible to obtain an advantageous effect of more stably maintaining the arrangement state of the thermal expansion member 300 with respect to the thermoelectric material unit 200. According to another embodiment of the present disclosure, the stopper may include only any one of the first and second stopper protrusions.

In the embodiment of the present disclosure illustrated and described above, the example in which the stopper 700 includes the stopper protrusion having a protruding shape has been described. However, according to another embodiment of the present disclosure, the stopper may include a stopper groove having a recessed groove shape.

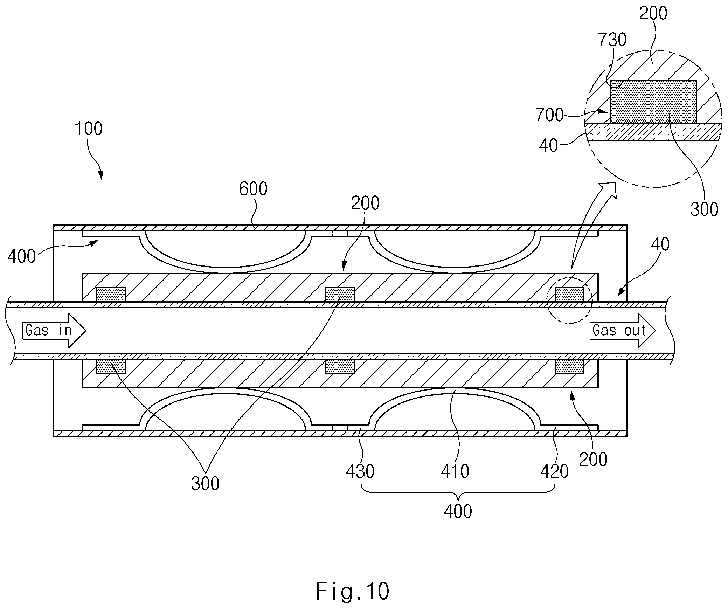

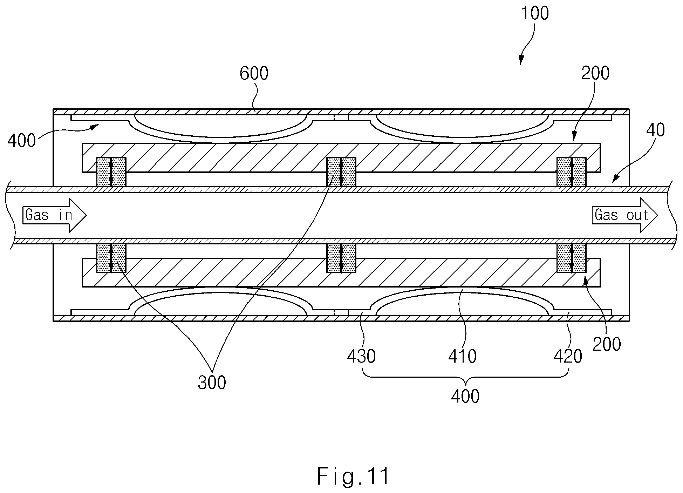

Referring to FIGS. 10 to 12, the stopper 700 may include a stopper groove 730 provided in at least any one of the thermoelectric material unit 200 and the heated body, and the thermal expansion member 300 may be accommodated in the stopper groove 730. For example, referring to FIGS. 10 and 11, the stopper groove 730 may be provided in one surface of the thermoelectric material unit 200 that faces the heated body, and the thermal expansion member 300 may be accommodated in the stopper groove 730.

For example, the stopper groove 730 may have a cross-sectional shape (e.g., a quadrangular cross-sectional shape) corresponding to a cross-sectional shape of the thermal expansion member 300. According to another embodiment of the present disclosure, the stopper groove may have a different cross-sectional shape (e.g., a circular cross-sectional shape) from the thermal expansion member.

In particular, the thermal expansion member 300 may be sized to be accommodated in the stopper groove 730 without protruding to the outside of the stopper groove 730 in the state in which the thermal expansion member 300 is contracted. The thermoelectric material unit 200 may be maintained to be in contact with the heated body in the state in which the thermal expansion member 300 is contracted (see FIG. 10). In contrast, when the thermal expansion member 300 is expanded, the thermal expansion member 300 may protrude to the outside of the stopper groove 730, which makes it possible to move the thermoelectric material unit 200 away from the heated body.

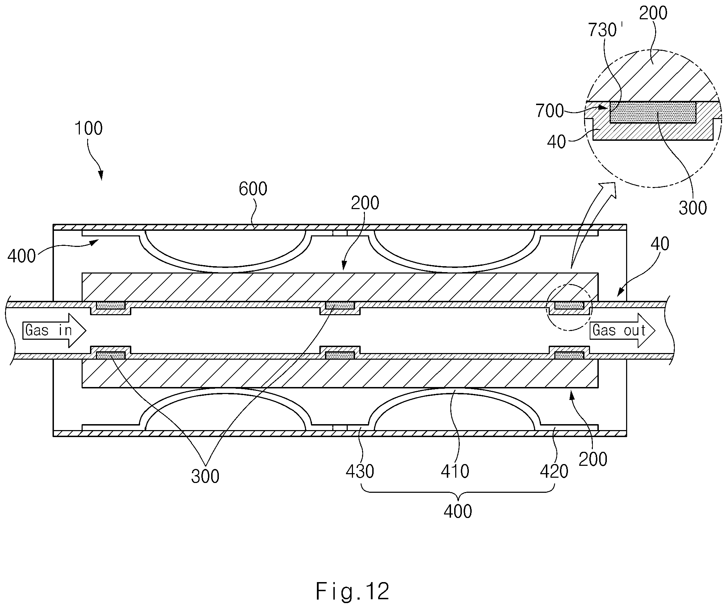

For reference, FIG. 10 illustrates the example in which the thermoelectric material unit 200 is in direct contact with the heated body. However, according to another embodiment of the present disclosure, the thermoelectric material unit 200 may come into contact with the heated body through the thermal conduction member (see 500 in FIG. 3). As another example, referring to FIG. 12, a stopper groove 730' may be provided in one surface of the heated body (e.g., the heat exchanger) that faces the thermoelectric material unit 200, and the thermal expansion member 300 may be accommodated in the stopper groove 730'.

According to the embodiment of the present disclosure described above, it is possible to obtain an advantageous effect of adjusting whether to supply the thermal energy to the thermoelectric generator based on the operating conditions of the vehicle. In particular, according to the embodiment of the present disclosure, it is possible to obtain an advantageous effect of inhibiting the thermal energy from being excessively supplied to the thermoelectric generator.

In addition, according to the embodiment of the present disclosure, it is possible to obtain an advantageous effect of improving the stability and reliability of the thermoelectric generator, minimizing the damage to the thermoelectric generator, and extending the lifespan of the thermoelectric generator. In addition, according to the embodiment of the present disclosure, it is possible to obtain an advantageous effect of actively adjusting whether to supply the thermal energy to the thermoelectric generator depending on the operating conditions without separately providing a bypass flow path. In addition, according to the embodiment of the present disclosure, it is possible to obtain an advantageous effect of simplifying the structure of the thermoelectric generator and improving the spatial utilization and the degree of design freedom of the thermoelectric generator.

While the embodiments have been described above, the embodiments are just illustrative and not intended to limit the present disclosure. It can be appreciated by those skilled in the art that various modifications and applications, which are not described above, may be made to the present embodiment without departing from the intrinsic features of the present embodiment. For example, the respective constituent elements specifically described in the embodiments may be modified and then carried out. Further, it should be interpreted that the differences related to the modifications and applications are included in the scope of the present disclosure defined by the appended claims.

### SYMBOL OF EACH OF THE ELEMENTS IN THE FIGURES

20: Engine
30: Exhaust pipe
40: Heat exchanger
42: Heat exchanger housing
44: Fin
100: Thermoelectric generator for vehicle
200: Thermoelectric material unit
210: First substrate
220: Unit thermoelectric material
222: N-type thermoelectric material
224: P-type thermoelectric material
230: First electrode
240: Second electrode
250: Second substrate
300: Thermal expansion member
400: Elastic member
410: Contact portion
420: Fixing portion
430: Movable portion
500: Thermal conduction member
600: Housing
700: Stopper
710: First stopper protrusion
720: Second stopper protrusion
730, 730': Stopper groove

## Claims

1. A thermoelectric generator for a vehicle, comprising:
a thermoelectric material unit including unit thermoelectric materials and movable in a direction in which the thermoelectric material unit approaches a heated body of a vehicle and a direction in which the thermoelectric material unit moves away from the heated body;
a thermal expansion member disposed between the thermoelectric material unit and the heated body and configured to be selectively expanded or contracted in response to a temperature of the heated body; and
an elastic member configured to elastically support a movement of the thermoelectric material unit relative to the heated body.

2. The thermoelectric generator of claim 1, wherein the thermoelectric material unit is in contact with the heated body when the thermal expansion member is contracted, and the thermoelectric material unit is spaced apart from the heated body when the thermal expansion member is expanded.

3. The thermoelectric generator of claim 2, further comprising:
a thermal conduction member disposed between the thermoelectric material unit and the heated body,
wherein the thermoelectric material unit comes into contact with the heated body through the thermal conduction member.

4. The thermoelectric generator of claim 1, further comprising:
a housing configured to surround the heated body,
wherein the elastic member is interposed between the housing and the thermoelectric material unit.

5. The thermoelectric generator of claim 4, wherein the elastic member includes:
a contact portion being in elastic contact with the thermoelectric material unit;
a fixing portion provided at a first end of the contact portion and fixed to the housing; and
a movable portion provided at a second end of the contact portion and disposed to be movable relative to the housing.

6. The thermoelectric generator of claim 5, wherein the contact portion, the fixing portion, and the movable portion are made by continuously bending a metal member.

7. The thermoelectric generator of claim 1, further comprising:
a stopper configured to restrict the thermal expansion member with respect to the thermoelectric material unit.

8. The thermoelectric generator of claim 7, wherein the stopper is provided on at least any one of the thermoelectric material unit and the heated body.

9. The thermoelectric generator of claim 8, wherein the stopper includes:
a first stopper protrusion disposed in a first direction; and
a second stopper protrusion connected to the first stopper protrusion and disposed in a second direction that intersects the first direction, and
wherein the first stopper protrusion and the second stopper protrusion cooperatively surround the thermal expansion member.

10. The thermoelectric generator of claim 7, wherein the stopper includes a stopper groove provided in at least any one of the thermoelectric material unit and the heated body, and the thermal expansion member is accommodated in the stopper groove.

11. The thermoelectric generator of claim 1, wherein the unit thermoelectric materials include at least any one of an N-type thermoelectric material and a P-type thermoelectric material.

## Patentansprüche

1. Thermoelektrischer Generator für ein Fahrzeug, umfassend:
eine Einheit aus thermoelektrischem Material, die Materialien der thermoelektrischen Einheit umfasst und in einer Richtung, in der sich die Einheit aus thermoelektrischem Material einem erwärmten Körper eines Fahrzeugs nähert, und in einer Richtung, in der sich die Einheit aus thermoelektrischem Material von dem erwärmten Körper entfernt, beweglich ist;
ein Wärmeausdehnungselement, das zwischen der Einheit aus thermoelektrischem Material und dem erwärmten Körper angeordnet ist und so eingerichtet ist, dass es in Reaktion auf eine Temperatur des erwärmten Körpers selektiv ausgedehnt oder zusammengezogen wird; und
ein elastisches Element, das so eingerichtet ist, dass es eine Bewegung der Einheit aus thermoelektrischem Material relativ zu dem erwärmten Körper elastisch unterstützt.

2. Thermoelektrischer Generator nach Anspruch 1, wobei die Einheit aus thermoelektrischem Material mit dem erwärmten Körper in Kontakt steht, wenn das Wärmeausdehnungselement zusammengezogen ist, und die Einheit aus thermoelektrischem Material von dem erwärmten Körper beabstandet ist, wenn das Wärmeausdehnungselement ausgedehnt ist.

3. Thermoelektrischer Generator nach Anspruch 2, des Weiteren umfassend:
ein Wärmeleitelement, das zwischen der Einheit aus thermoelektrischem Material und dem erwärmten Körper angeordnet ist,
wobei die Einheit aus thermoelektrischem Material durch das Wärmeleitelement in Kontakt mit dem erwärmten Körper kommt.

4. Thermoelektrischer Generator nach Anspruch 1, des Weiteren umfassend:
ein Gehäuse, das dafür eingerichtet ist, den erwärmten Körper zu umgeben,
wobei das elastische Element zwischen dem Gehäuse und der Einheit aus thermoelektrischem Material angeordnet ist.

5. Thermoelektrischer Generator nach Anspruch 4, wobei das elastische Element aufweist:
einen Kontaktabschnitt, der in elastischem Kontakt mit der Einheit aus thermoelektrischem Material steht;
einen Befestigungsabschnitt, der an einem ersten Ende des Kontaktabschnitts angeordnet und an dem Gehäuse befestigt ist;
und
einen beweglichen Abschnitt, der an einem zweiten Ende des Kontaktabschnitts vorhanden und so angeordnet ist, dass er relativ zum Gehäuse beweglich ist.

6. Thermoelektrischer Generator nach Anspruch 5, wobei der Kontaktabschnitt, der Befestigungsabschnitt und der bewegliche Abschnitt durch kontinuierliches Biegen eines Metallelements hergestellt sind.

7. Thermoelektrischer Generator nach Anspruch 1, des Weiteren umfassend:
einen Endanschlag, der dafür eingerichtet ist, das Wärmeausdehnungselement in Bezug auf die Einheit aus thermoelektrischem Material zu begrenzen.

8. Thermoelektrischer Generator nach Anspruch 7, wobei der Endanschlag an mindestens einem von der Einheit aus thermoelektrischem Material und dem erwärmten Körper angeordnet ist.

9. Thermoelektrischer Generator nach Anspruch 8, wobei der Endanschlag umfasst:
einen ersten Endanschlagvorsprung, der in einer ersten Richtung angeordnet ist; und
einen zweiten Endanschlagvorsprung, der mit dem ersten Endanschlagvorsprung verbunden und in einer zweiten Richtung angeordnet ist, die die erste Richtung schneidet, und
wobei der erste Endanschlagvorsprung und der zweite Endanschlagvorsprung im Zusammenwirken das Wärmeausdehnungselement umgeben.

10. Thermoelektrischer Generator nach Anspruch 7, wobei der Endanschlag eine Endanschlagnut aufweist, die in mindestens einer von der Einheit aus thermoelektrischem Material und dem erwärmten Körper angeordnet ist, und das Wärmeausdehnungselement in der Endanschlagnut aufgenommen ist.

11. Thermoelektrischer Generator nach Anspruch 1, wobei die Materialien der thermoelektrischen Einheit mindestens eines von einem thermoelektrischen Material vom N-Typ und einem thermoelektrischen Material vom P-Typ umfassen.

## Revendications

1. Générateur thermoélectrique pour un véhicule, comprenant :
une unité de matériau thermoélectrique comportant des matériaux thermoélectriques unitaires et mobile dans une direction dans laquelle l'unité de matériau thermoélectrique s'approche d'un corps chauffé d'un véhicule et une direction dans laquelle l'unité de matériau thermoélectrique s'éloigne du corps chauffé ;
un élément de dilatation thermique disposé entre l'unité de matériau thermoélectrique et le corps chauffé et
configuré pour être sélectivement dilaté ou contracté en réponse à une température du corps chauffé ; et
un élément élastique conçu pour supporter élastiquement un mouvement de l'unité de matériau thermoélectrique par rapport au corps chauffé.

2. Générateur thermoélectrique selon la revendication 1, dans lequel l'unité de matériau thermoélectrique est en contact avec le corps chauffé lorsque l'élément de dilatation thermique est contracté, et l'unité de matériau thermoélectrique est espacée du corps chauffé lorsque l'élément de dilatation thermique est dilaté.

3. Générateur thermoélectrique selon la revendication 2, comprenant en outre :
un élément de conduction thermique disposé entre l'unité de matériau thermoélectrique et le corps chauffé,
dans lequel l'unité de matériau thermoélectrique vient en contact avec le corps chauffé par l'intermédiaire de l'élément de conduction thermique.

4. Générateur thermoélectrique selon la revendication 1, comprenant en outre :
un boîtier configuré pour entourer le corps chauffé,
dans lequel l'élément élastique est interposé entre le boîtier et l'unité de matériau thermoélectrique.

5. Générateur thermoélectrique selon la revendication 4, dans lequel l'élément élastique comprend :
une partie de contact qui en contact élastique avec l'unité de matériau thermoélectrique ;
une partie de fixation prévue au niveau d'une première extrémité de la partie de contact et fixée au boîtier ; et
une partie mobile prévue au niveau d'une seconde extrémité de la partie de contact et disposée pour être mobile par rapport au boîtier.

6. Générateur thermoélectrique selon la revendication 5, dans lequel la partie de contact, la partie de fixation, et la partie mobile sont réalisées en pliant de façon continue un élément métallique.

7. Générateur thermoélectrique selon la revendication 1, comprenant en outre :
une butée configurée pour restreindre l'élément de dilatation thermique par rapport à l'unité de matériau thermoélectrique.

8. Générateur thermoélectrique selon la revendication 7, dans lequel la butée est prévue sur au moins l'un quelconque parmi l'unité de matériau thermoélectrique et le corps chauffé.

9. Générateur thermoélectrique selon la revendication 8, dans lequel la butée comporte :
une première saillie de butée disposée dans une première direction ; et
une seconde saillie de butée reliée à la première saillie de butée et disposée dans une seconde direction qui croise la première direction, et
dans lequel la première saillie de butée et la seconde saillie de butée entourent de manière coopérative l'élément de dilatation thermique.

10. Générateur thermoélectrique selon la revendication 7, dans lequel la butée comporte une rainure de butée prévue dans au moins l'un quelconque parmi l'unité de matériau thermoélectrique et le corps chauffé, et l'élément de dilatation thermique est logé dans la rainure de butée.

11. Générateur thermoélectrique selon la revendication 1, dans lequel les matériaux thermoélectriques unitaires comportent au moins l'un quelconque parmi un matériau thermoélectrique de type N et un matériau thermoélectrique de type P.
